# EUROPEAN PATENT SPECIFICATION

(11) **EP 3 489 479 B1**
(45) Date of publication and mention of the grant of the patent: **09.09.2020**
(21) Application number: 18207193.6
(22) Date of filing: 20.11.2018
(51) Int. Cl.: F01N 3/20, G01F 23/30, H01H 36/02, G01F 23/74, F02D 41/28

(54) **ELECTRONIC SYSTEM COMPRISING AN INTERMEDIATE PRINTED CIRCUIT BOARD FOR A FLUID PROPERTY SENSOR AND FLUID PROPERTY SENSOR**
ELEKTRONISCHES SYSTEM MIT EINER ZWISCHENLEITERPLATTE FÜR EINEN FLUIDEIGENSCHAFTSSENSOR UND FLUIDEIGENSCHAFTSSENSOR
SYSTÈME ÉLECTRONIQUE COMPRENANT UNE CARTE DE CIRCUIT IMPRIMÉ INTERMÉDIAIRE POUR UN CAPTEUR DE PROPRIÉTÉS DE FLUIDE ET CAPTEUR DE PROPRIÉTÉS DE FLUIDE

(30) Priority: 23.11.2017 CN 201721586493 U
(43) Date of publication of application: 29.05.2019
(73) Proprietor: Wema System AS, 5258 Blomsterdalen (NO); MEAS France, 31300 Toulouse (FR)
(72) Inventor: ZIEMAK, Maciej, 55-010 Kotowice (PL); GROZEA, Ion, 5254 Sandsli (NO); RUSAK, Marcin, 5056 Bergen (NO); ELIASSEN, Bengt, 5236 Radal (NO); JUDERSLEBEN, Conrad, 5089 Bergen (NO); FERNANDEZ, Jose, 5004 Bergen (NO); JANSSON, Niklas, 5232 Paradis (NO); RUIZ, Rafael Ferrer, 31200 Toulouse (FR)
(74) Representative: Grünecker Patent- und Rechtsanwälte PartG mbB

(56) References cited:
- EP-A1- 1 669 743
- WO-A1-2012/081773
- DE-A1-102007 004 822
- US-A- 5 627 523
- US-A1- 2015 337 708
- US-A1- 2016 349 157

## Description

The invention relates to an electronic system comprising an intermediate printed circuit board for a fluid property sensor and a fluid property sensor with such an electronic system.

The invention relates, in particular, to an electronic system for a urea sensor and a urea sensor with such an electronic system.

Fluid property sensors are widely used in vehicles for example to sense the level of fluids like fuel level in a fuel tank or more recently the level and/or quality of urea in a urea tank. This fluid, for example Diesel Exhaust Fluid (DEF) or Adblue, is used in reduction systems for reducing harmful NOx components in the exhaust gases of Diesel engines. To achieve an efficient reduction of NOx in the exhaust gas, it is important to analyse the quality of the urea solutions and their level inside the tank.

EP 1 669 743 A1 discloses such a urea concentration identification device for identifying a urea concentration in urea solution stored in a tank.

To realize a level measurement a bank of reed switches provided on a printed circuit board are aligned one besides the other and are positioned inside a tube, e.g. made of polypropylene (PP). A magnetic float surrounds the tube and depending on its position on the urea solution will lead to the switching of a corresponding switch. From the corresponding signal the level of the solution in the tank can be established.

Besides the level measurement, further properties of the solution can be sensed as well, e.g. the temperature, the concentration or the presence of bubbles can be determined.

There is a continuous demand to reduce size but also weight of the sensors without, however, loosing in accuracy or measurement range. As the space available for the PCB inside the tube is limited and as further functionalities have to be added to the PCB, like grounding or protection components, it is actually impossible to use the entire extent of the PCB board to place the switches. Furthermore depending on the customer requirements in particular with respect to the connectivity of the sensor to the harness of the vehicle it is necessary to adapt the PCB and therefore it is not possible to use one standardized PCB.

It is therefore the object of the present invention to improve the design of a fluid property sensor such that varying customer requirements can be taken into account in a simplified manner.

The object of the invention is achieved with an electronic system for a fluid property sensor according to claim 1. This electronic system comprises: a printed circuit board (PCB) for analyzing a property of a fluid and a connector for connecting the fluid property sensor and is characterized in further comprising a separate intermediate printed circuit board (iPCB) electrically connected between the printed circuit board and the connector. The object is achieved for a urea sensor for installation in a urea tank of a vehicle.

To be able to standardize the printed circuit board for analyzing the property of the fluid a separate intermediate printed circuit board is electrically connected between the printed circuit board and the connector.

According to an embodiment, the intermediate printed circuit board can be connected to metallic parts of the fluid property sensor and configured to provide different options for electrical connections, e.g. battery minus and/or ground, of the fluid property sensor when mounted, in particular into the urea tank mounted in a vehicle. This reduces the components necessary on the PCB.

The intermediate printed circuit board comprises circuit protection components comprising electrostatic discharge (ESD) protection circuits which shall protect the signals to and from a bus of a vehicle, e.g. a CAN bus. This reduces the components necessary on the PCB, but also reduces the risk or even prevents possible harmful signals to reach the more sensitive electronics part of the electronic system or fluid property sensor. Besides or instead of an ESD protection, the intermediate printed circuit board provides an overvoltage protection and/or filter function for the power provided by a vehicle's battery. The intermediate printed circuit board furthermore can provide termination to the CAN bus, depending on customer requirements. This provides the option to be either permanently or selectively connected by a vehicle harness. The later option makes it possible to use identical sensors either as an end node or a stub node on the vehicle's CAN bus, which allos reducing the amount of different articles.

According to an embodiment, the intermediate printed circuit board can comprise more connections towards the connector than to the printed circuit board. Thus, changing customer requirements for the electrical interface can be taken care of while keeping the same technical design for the PCB. The intermediate printed circuit board can, for instance, accommodate various CAN bus interfaces, depending on different customer preferences and specifications.

According to an embodiment, two or more connections can be connected to each other towards the side of the connector. This will provide ability to customize the device according to customer specifications. In one example, redundancy capabilities can be provided to the electronic system as two wires can be connected to the intermediate PCB that carry the same signal and/or both carry power. In another example of customization, the two or more connections are used to allow connection of the sensor in a daisy chain configuration with an input-output series connection.

According to an embodiment, the wire size towards the connector can be different, in particular larger, than the wire size towards the printed circuit board. This allows to optimize the sensor design, in particular the necessary volume for the wires inside the sensor can be reduced even in cases where outside the sensor larger diameter wires are wanted or needed.

According to an embodiment, at most four wires connect the printed circuit board to the intermediate circuit board. Using at most four wires further helps in reducing the volume needed for the electronic system. A typical configuration for the interface provided by the iPCB provides two wires to connect to the battery of the vehicle and two wires to connect the electrically balanced CAN bus signals, e.g. CAN H and CAN L.

According to an embodiment, the one or more wires for the connection between the printed circuit board and the intermediate circuit board can have a section of 0,25mm² or less, in particular 0,21mm² or less. In other terms wires with AWG24 or thinner, preferably AWG 25 or AWG 26 could be used. Using this kind of thin wires reduces the space needed between the PCB and the iPCB.

According to an embodiment, the connection between the printed circuit board and the intermediate circuit board can be realized using a connector. In this realization, wires can be soldered directly to the PCB and on the other side of the wires, the terminal ends are connected to a connector that mates with a corresponding connector on the iPCB. This will simplify the assembly process of the system.

According to an embodiment, the printed circuit board can comprise a plurality of switches, in particular reed switches configured to sense the level of fluid in a tank. The reed switches together with a float can be used to analyze the level of a fluid in a tank. The magnetic field of the float will switch the reed switches and a corresponding electrical signal will then be transmitted from the PCB via the iPCB towards the connector. As other components are placed on the iPCB the PCB can be used to place reed switches along its entire height whereas in the case of placing other components on the PCB the possible range of height measurements will be limited.

The invention also relates to a fluid property sensor being aurea sensor for installation in a urea tank that can be used for measuring one or more properties of a fluid comprising an electronic system as described above. Using the iPCB allows adapting the design of the fluid property sensor in a simple way to varying customer requirements. It allows the easy transmission of signals and power between the electronics of the sensor and the connector of the customer.

According to an embodiment, the fluid property sensor can comprise a lid for closing a tank with the fluid property sensor, in particular the urea tank, wherein the intermediate circuit board can be mounted on or into the lid. Using the lid to position the iPCB keeps the volume of the sensor reduced.

According to an embodiment, the intermediate circuit board can be mount to the lid using at least one screw, wherein the urea sensor can be furthermore configured to enable grounding of the sensor components via the at least one screw and the lid. By using the same component to attach the iPCB and to ensure grounding of the metallic parts of the fluid property sensor, the amount of components of the sensor can be kept small.

According to an embodiment, the fluid property sensor can be configured to sense the level of a fluid in the tank using the printed circuit board comprising switches, in particular reed switches. As other components can be placed on the iPCB, the entire available surface of the PCB can be used for the reed switches. Thus, the effective height range the sensor can determine is increased compared to the sensors known in the art.

The invention will now be described in greater detail using advantageous embodiments in an exemplary manner and with reference to the drawings. The described embodiments are merely possible configurations .

The drawings show in the
Figure 1: schematically illustrates a three dimensional partial view of a fluid property sensor according to the invention,
Figure 2: schematically illustrates in a partially exploded view the electronic system according to the invention and used in the fluid property sensor illustrated in figure 1,
Figure 3: illustrates one example of an intermediate printed circuit board.

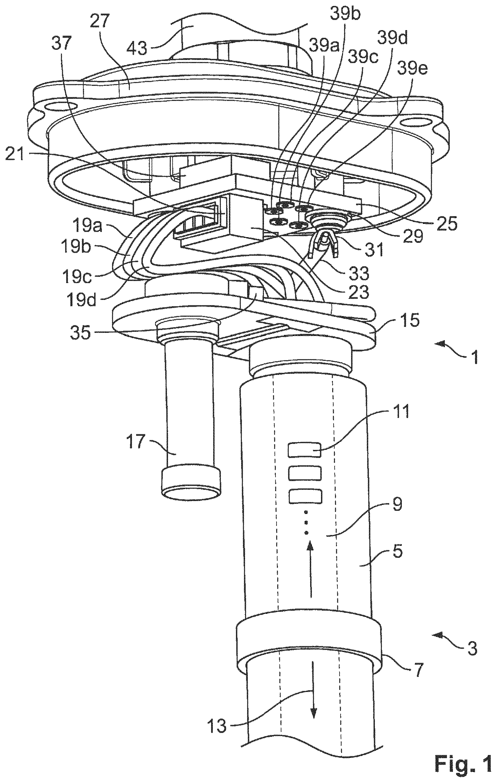

Figure 1 shows a partial view of a fluid property sensor 1 according to the invention. The fluid property sensor 1 in this embodiment relates to urea sensor for use in a vehicle. The urea sensor is used to sense the level of urea in a tank (not shown). The urea sensor can also be configured to sense further properties, like temperature, the concentration, the presence of bubbles etc. Urea is used in vehicles to reduce NOx components in the exhaust gas of Diesel engines.

The fluid property sensor 1 comprises a level sensor 3. The level sensor 3 comprises a tube 5, e.g. made out of polypropylene (PP) or any other suitable material and a float 7 surrounding the tube 5. A printed circuit board 9 (PCB) is positioned inside the tube 5, as illustrated by dotted lines. The printed circuit board comprises a plurality of switches 11, in particular reed switches. The float 7 has magnetic properties such that depending on its position with respect to the tube 5, indicated by the arrows 13, a corresponding switch 11 will change its state, e.g. from open into closed which is due to the presence of the magnetic field around the float 7.

The tube 5 is mounted to a plate 15 mechanically connecting the tube 5 to a metallic connection rod 17. The connection rod 17 carries other parts of the sensor 1, like a temperature or a quality sensor (not shown), e.g. an ultrasound or optical sensor.

Four electric wires 19a-19d are leaving the tube 5 via a sealed interface (not shown) at the upper end of the tube 5. These wires 19a to 19d provide signal and/or power to and from the PCB 9. The wires 19a-19d in this embodiment terminate within a first connector 21. The wires 19a-19d are soldered on the PCB 9. The wires used have a cross section of less than 0,25mm², in particular AWG values of AWG 24 or thinner, preferably one of AWG24 to AWG26.

The first connector 21 is connected to a mating second connector 23 provided on an intermediate printed circuit board 25 (iPCB). The iPCB 25 is fixed on the inside of a lid 27 used to mount the fluid property sensor 1 inside a tank (not shown) and for closing said tank. One or more screws 29 are used to fix the iPCB 25 to the lid 27. Using a cable shoe 31 or any other suitable means, like a soldering pad, a grounding wire 33 is in electrical contact and mechanically fixed to the screw 29 and enables the grounding of the metallic parts of the fluid property sensor 1. Thereto, the grounding wire 33 is electrically connected using a further cable shoe 35 to the metallic connection rod 17.

Using the screw 29 to connect the grounding wire 33 to the lid 27, which in turn provides grounding as it is in contact with the chassis of the vehicle into which the fluid property sensor 1 is mount, it is not necessary to use an additional connecting means. Nevertheless, according to a variant it is also possible to provide grounding via the grounding wire 33 soldered onto a dedicated soldering pad on the iPCB 25 in turn in electrical contact via the lid 27 with the chassis of the vehicle.

The iPCB 25 further comprises circuit protection components 37 :o protect the sensor against electrostatic discharge (ESD) and/or overvoltage protection and/or one or more filters.

The iPCB 25 also comprises additional connection pads 39a to 39e to which wires of the electrical connection towards the external connector 43 are connected, e.g. by soldering.

According to the invention more wires 41 could be connected to the iPCB 25 than wires 19a-19d coming from the tube 5. Thus particular customer requirements can be taken into account. In one example, it is thus possible to duplicate connections to provide redundancy. Thus two wires out of the wires 41 are in contact with wire 19a, two other wires are in contact with wire 19b etc. Furthermore, the size of the wires 41 and 19a to 19d might be different. In particular, the wires 41 can be thicker as the wires 19a to 19d leaving the tube 5 as the design constraints are lower outside the tube 5. In another variant, input-output series connections could be realized.

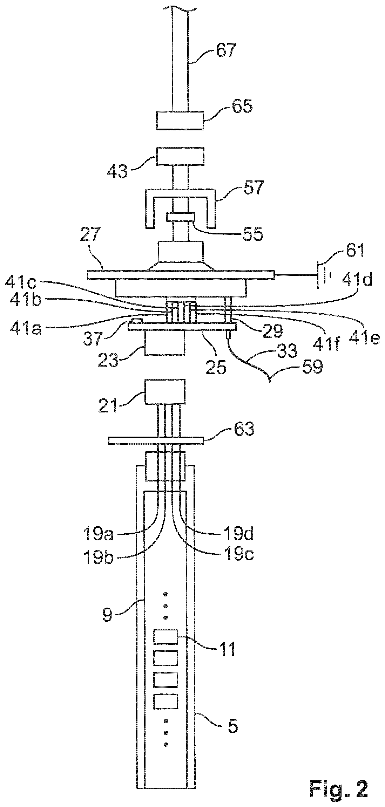

Figure 2 schematically illustrates in a partially explode view the electronic system 51 according to the invention used in the fluid property sensor 1 as illustrated in figure 1.

Elements with the same reference numeral already used in Figure 1 will not be described in detail again but reference is made to their description.

The electronic system 51 comprises the PCB 9, the iPCB 25 and the external connector 43. The PCB 9 comprises the switches 11, here reed switches, used to establish the level of urea in the tank (not shown). Four wires 19a to 19d are connected to the PCB 9 by soldering. The four wires are also connected to the first connector 21 mating the second connector 23 of the iPCB 25. Wires 41a to 41f are connected to the iPCB 25, e.g. by soldering or using additional connectors (not shown). The wires 41a to 41f extend to the external connector 43.

In the figure six wires 41a to 41f are illustrated. However, more or less wires could actually be present. Furthermore four wires 19a to 19d are illustrated. Nevertheless more or less wires could be used as well. According to a variant, more wires are used between the iPCB 25 and the external connector 43 than wires between the iPCB 25 and the PCB 9, as illustrated. Furthermore the wires 41a to 41f can be thicker than the wires 19a to 19d.

The wires 41a to 41f pass through an opening 53 in the lid 27. A seal 55 and a cover 57 are used to fix the wires and seal the connection. The cover 57 can be designed such that it also provides stress relief for the whole device.

The grounding wire 33 is connected to the iPCB 25 with one terminal end and the other terminal end 59 can be connected to metallic parts (not shown in figure 2) of the fluid property sensor. Via screw 29 the grounding wire 33 can be connected to the lid 27, that is grounded 61 by an electrical connection to the chassis of the vehicle (not shown). The iPCB 25 furthermore comprises the circuit protection components 37.

Figure 2 also illustrates further features in relation to the electronic system 51. The PCB 11 is positioned inside tube 5. The tube 5 is sealed using a lock feature 63 through which pass the wires 19a to 19d.

The external connector 43 can be electrically and mechanically connected to the mating connector 65 of the vehicle harness 67.

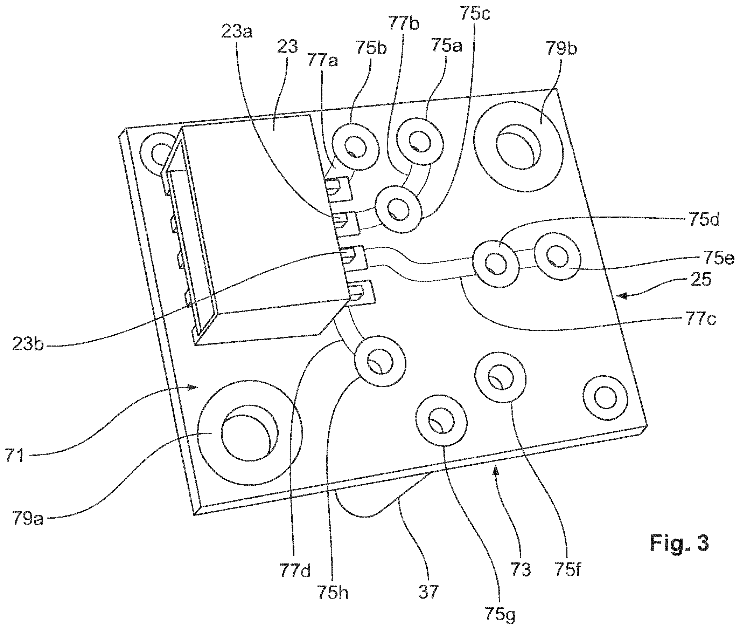

Figure 3 illustrates one example of an intermediate printed circuit board 25. Elements with the same reference numeral already used in Figure 1 or 2 will not be described in detail again but reference is made to their description. The second connector 23 is positioned on the one main side 71 of the iPCB 25 towards the tube 5 with the PCB 9 in the mounted state, whereas circuit protection components 37 are positioned on the other main side 73 of the iPCB 25.

Metallically coated vias 75a to 75h link the one and the other main side 71 and 73 of the iPCB 25. The wires 41a to 41f can be soldered to vias using bonding pads on the other main side 73 (not shown).

Connection lines 77a to 77d are provided to electrically connect the vias to the second connector 23. In this example, via 75a and 75c are connected together to one entry 23a of the second connector 23 and via 75d and 75e are connected together to another entry 23b of the second connector. Thus a redundancy can be provided in case two corresponding wires out of the wires 41a to 41f are connected to the corresponding bonding pads. Thus in case one wire breaks, the other wire can still provide the signal or the power necessary to the functioning of the fluid property sensor. According to a variant, connection lines and vias can be arranged such as to provide a input output series connection to connect the sensor in a so called daisy chain configuration.

The metallically coated holes 79a and 79b can be used to fix the iPCB 25 to the lid 27 as shown in Figure 1 and 2 using screws 29. Using the metallic coating it becomes possible to ground the iPCB 25 and other metallic parts of the fluid property sensor via the lid 27 and a connection to the chassis of the vehicle in which the sensor is built in.

By moving the grounding feature and the circuit protection to the iPCB 25, the PCB 9 can be dedicated to the measurement of the level of the urea fluid. Thus height for the measured level can be saved in the tube, as no space has to be reserved for these extra features. In addition due to the use of small wires 19a to 19d and the use of only four wires, the space needed inside the tube 5 can be reduced. Furthermore, the design of the PCB 9 and its connection to the iPCB 25 can be kept the same independent of the requirements of the users. Only the iPCB 25 has to be adapted, this simplifies the design and allows a better standardization of the parts used for the fluid property sensor 1.

Modifications to embodiments of the invention described in the foregoing are possible without departing from the scope of the invention as defined by the accompanying claims.

### Reference numerals:

- 1: fluid property sensor
- 3: level sensor
- 5: tube
- 7: float
- 9: printed circuit board (PCB)
- 11: switches
- 13: arrow
- 15: plate
- 17: metallic connection rod
- 19a-19d: wires
- 21: first connector
- 23: second connector
- 23a, 23b: entries of the second connector
- 25: intermediate printed circuit board iPCB
- 27: lid
- 29: screw
- 31: cable shoe
- 33: grounding wire
- 35: cable shoe
- 37: circuit protection components
- 39a-39e: connection pads
- 41a-41f: wires
- 43: external connector
- 51: electronic system
- 53: opening
- 55: seal
- 57: cover
- 59: terminal end of grounding wire
- 61: ground
- 63: lock feature
- 65: mating connector
- 67: vehicle harness
- 71: first main side of the iPCB
- 73: other main side of the iPCB
- 75a-75h: metallically coated vias
- 77a- 77d: connection lines
- 79a, 79b: metallically coated holes

## Claims

1. Electronic system for a fluid property sensor (1) being a urea sensor for installation in a urea tank of a vehicle, comprising:
a printed circuit board (9) for analyzing a property of a fluid and a connector (43) for connecting the fluid property sensor (1) and
a separate intermediate printed circuit board (25) electrically connected between the printed circuit board (9) and the connector (43);
**characterized in that** the intermediate printed circuit board (25) comprises circuit protection components (37), comprising one or more electrostatic discharge (ESD) protection and/or one or more overvoltage and/or one or more filter circuits.

2. Electronic system according to claim 1, wherein the intermediate printed circuit board (25) is connected to metallic parts (17) of the fluid property sensor (1) and configured to provide grounding of the fluid property sensor (1) when mounted into the urea tank mounted in a vehicle.

3. Electronic system according to one of claims 1 to 2, wherein the intermediate printed circuit board (25) comprises more connections towards the connector (43) than to the printed circuit board (9).

4. Electronic system according to claim 3, wherein towards the connector (43) two or more connections are connected to each other to provide redundancy capabilities to the electronic system or provide a connection of the sensor in daisy chain configuration with an input-output-series connection.

5. Electronic system according to one of claims 1 to 4, wherein the wire size towards the connector (43) is larger, than the wire size towards the printed circuit board (9).

6. Electronic system according to claim 5, wherein at most four wires (19a-19d) connect the printed circuit board (9) to the intermediate circuit board (25).

7. Electronic system according to one of claims 1 to 6, wherein the one or more wires for the connection between the printed circuit board (9) and the intermediate circuit board (25) have a section of 0,25mm² or less, in particular 0,21 mm² or less.

8. Electronic system according to one of claims 1 to 6, wherein the connection between the printed circuit board (9) and the intermediate circuit board (25) is realized using a connector (21, 23).

9. Electronic system according to one of claims 1 to 8, wherein the printed circuit board (9) comprises a plurality of switches (11) being reed switches, configured to sense the level of fluid in a tank.

10. Fluid property sensor, being a urea sensor for installation in a urea tank, that can be used for measuring one or more properties of a fluid comprising an electronic system according to one of claims 1 to 9.

11. Fluid property sensor according to claim 10, further comprising a lid (27) for closing a tank with the fluid property sensor being the urea tank, wherein the intermediate circuit board (25) is mounted on or into the lid (27).

12. Fluid property sensor according to claim 10 or 11, wherein the intermediate circuit board (25) is mounted to the lid (27) using at least one screw (29), wherein the urea sensor is furthermore configured to enable grounding of the sensor components via the at least one screw (29) and the lid (27).

13. Fluid property sensor according to one of claims 10 to 12 in combination with the electronic system according to claim 10 configured to sense the level of a fluid in the tank using the printed circuit board (9) comprising switches (11) being reed switches.

## Patentansprüche

1. Elektronisches System für einen Sensor (1) für Flüssigkeitseigenschaften, der ein Harnstoffsensor zur Installation in einem Harnstofftank eines Fahrzeugs ist, umfassend:
eine Leiterplatte (9) zum Analysieren einer Eigenschaft einer Flüssigkeit und einen Verbinder (43) zum Anschließen des Sensors (1) für Flüssigkeitseigenschaften
sowie
eine separate Zwischen-Leiterplatte (25), die elektrisch zwischen die Leiterplatte (9) und den Verbinder (43) geschaltet ist;
**dadurch gekennzeichnet, dass**
die Zwischen-Leiterplatte (25) Schaltungsschutz-Komponenten (37) umfasst, die einen oder mehrere Einrichtung/en zum Schutz gegen elektrostatische Entladung (ESD) und/oder eine oder mehrere Überspannungsschutz-Schaltung/en und/oder eine oder mehrere Filter-Schaltung/en umfassen.

2. Elektronisches System nach Anspruch 1, wobei die Zwischen-Leiterplatte (25) mit metallischen Teilen (17) des Sensors (1) für Flüssigkeitseigenschaften verbunden und so ausgeführt ist, dass sie Erdung des Sensors (1) für Flüssigkeitseigenschaften bewirkt, wenn dieser in dem in einem Fahrzeug installierten Harnstofftank angebracht wird.

3. Elektronisches System nach einem der Ansprüche 1 bis 2, wobei die Zwischen-Leiterplatte (25) mehr Verbindungen zu dem Verbinder (43) als zu der Leiterplatte (9) umfasst.

4. Elektronisches System nach Anspruch 3, wobei zwei oder mehr Verbindungen zu dem Verbinder (43) miteinander verbunden sind, um dem elektronischen System Redundanz-Kapazitäten zu verleihen oder eine Verbindung des Sensors in Verkettungs-Konfiguration mit einer Eingang/Ausgang-Reihenverbindung bereitzustellen.

5. Elektronisches System nach einem der Ansprüche 1 bis 4, wobei die Drahtgröße zu dem Verbinder (43) größer ist als die Drahtgröße zu der Leiterplatte (9).

6. Elektronisches System nach Anspruch 5, wobei maximal vier Drähte (19a-19d) die Leiterplatte (9) mit der Zwischen-Leiterplatte (25) verbinden.

7. Elektronisches System nach einem der Ansprüche 1 bis 6, wobei der eine oder die mehreren Draht/Drähte für die Verbindung zwischen der Leiterplatte (9) und der Zwischen-Leiterplatte (25) einen Querschnitt von 0,25 mm² oder weniger, insbesondere 0,21 mm² oder weniger, haben.

8. Elektronisches System nach einem der Ansprüche 1 bis 6, wobei die Verbindung zwischen der Leiterplatte (9) und der Zwischen-Leiterplatte (25) unter Verwendung eines Verbinders (21, 23) realisiert wird.

9. Elektronisches System nach einem der Ansprüche 1 bis 8, wobei die Leiterplatte (9) eine Vielzahl von Schaltern (11) umfasst, die Reed-Schalter sind und die zum Erfassen des Flüssigkeitspegels in einem Tank ausgeführt sind.

10. Sensor für Flüssigkeitseigenschaften, bei dem es sich um einen Harnstoffsensor zur Installation in einem Harnstofftank handelt, der zum Messen einer oder mehrerer Eigenschaft/en einer Flüssigkeit eingesetzt werden kann und ein elektronisches System nach einem der Ansprüche 1 bis 9 umfasst.

11. Sensor für Flüssigkeitseigenschaften nach Anspruch 10, der des Weiteren einen Deckel (27) zum Verschließen eines Tanks mit dem Sensor für Flüssigkeitseigenschaften umfasst, der der Harnstofftank ist, wobei die Zwischen-Leiterplatte (25) an oder in dem Deckel (27) angebracht ist.

12. Sensor für Flüssigkeitseigenschaften nach Anspruch 10 oder 11, wobei die Zwischen-Leiterplatte (25) unter Verwendung wenigstens einer Schraube (29) an dem Deckel (27) angebracht ist und der Harnstoffsensor des Weiteren so ausgeführt ist, dass er Erdung der Sensor-Komponenten über die wenigstens eine Schraube (29) und den Deckel (27) ermöglicht.

13. Sensor für Flüssigkeitseigenschaften nach einem der Ansprüche 10 bis 12 in Kombination mit dem elektronischen System nach Anspruch 10, ausgeführt zum Erfassen eines Flüssigkeitspegels in dem Tank unter Verwendung der Leiterplatte (9), die Schalter (11) umfasst, die Reed-Schalter sind.

## Revendications

1. Système électronique pour un capteur de propriété de fluide (1) qui est un capteur d'urée destiné à être installé dans un réservoir d'urée d'un véhicule, comprenant :
une carte de circuit imprimé (9) pour analyser une propriété d'un fluide et un connecteur (43) pour connecter le capteur de propriété de fluide (1)
et
une carte de circuit imprimé intermédiaire séparée (25) connectée électriquement entre la carte de circuit imprimé (9) et le connecteur (43) ;
**caractérisé en ce que**
la carte de circuit imprimé intermédiaire (25) comprend des composants de protection de circuit (37), comprenant un ou plusieurs circuits de protection contre des décharges électrostatiques (ESD) et/ou un ou plusieurs circuites contre de surtensions et/ou un ou plusieurs circuits de filtrage.

2. Système électronique selon la revendication 1, dans lequel la carte de circuit imprimé intermédiaire (25) est connectée à des parties métalliques (17) du capteur de propriété de fluide (1) et configurée pour permettre la mise à la terre du capteur de propriété de fluide (1) lorsqu'il est monté dans le réservoir d'urée monté dans un véhicule.

3. Système électronique selon l'une des revendications 1 à 2, dans lequel la carte de circuit imprimé intermédiaire (25) comprend plus de connexions vers le connecteur (43) que vers la carte de circuit imprimé (9).

4. Système électronique selon la revendication 3, dans lequel vers le connecteur (43), deux ou plus de deux connexions sont connectées entre elles pour fournir des capacités de redondance au système électronique ou pour fournir une connexion du capteur selon une configuration en guirlande avec une connexion série entrée-sortie.

5. Système électronique selon l'une des revendications 1 à 4, dans lequel la taille de fil vers le connecteur (43) est plus grande que la taille de fil vers la carte de circuit imprimé (9).

6. Système électronique selon la revendication 5, dans lequel au plus quatre fils (19a-19d) connectent la carte de circuit imprimé (9) à la carte de circuit intermédiaire (25).

7. Système électronique selon l'une des revendications 1 à 6, dans lequel les un ou plusieurs fils pour la connexion entre la carte de circuit imprimé (9) et la carte de circuit intermédiaire (25) ont une coupe de 0,25 mm² ou moins, en particulier 0,21 mm² ou moins.

8. Système électronique selon l'une des revendications 1 à 6, dans lequel la connexion entre la carte de circuit imprimé (9) et la carte de circuit intermédiaire (25) est réalisée en utilisant un connecteur (21, 23).

9. Système électronique selon l'une des revendications 1 à 8, dans lequel la carte de circuit imprimé (9) comprend une pluralité de commutateurs (11) qui sont des commutateurs Reed, configurés pour détecter le niveau de fluide dans un réservoir.

10. Capteur de propriété de fluide, qui est un capteur d'urée destiné à être installé dans un réservoir d'urée, qui peut être utilisé pour mesurer une ou plusieurs propriétés d'un fluide comprenant un système électronique selon l'une des revendications 1 à 9.

11. Capteur de propriété de fluide selon la revendication 10, comprenant en outre un couvercle (27) pour fermer un réservoir avec le capteur de propriété de fluide qui est le réservoir d'urée, dans lequel la carte de circuit intermédiaire (25) est montée sur ou dans le couvercle (27).

12. Capteur de propriété de fluide selon la revendication 10 ou 11, dans lequel la carte de circuit intermédiaire (25) est monté sur le couvercle (27) en utilisant au moins une vis (29), le capteur d'urée étant de plus configuré pour permettre la mise à la terre des composants du capteur via la au moins une vis (29) et le couvercle (27).

13. Capteur de propriété de fluide selon l'une des revendications 10 à 12 en combinaison avec le système électronique selon la revendication 10, configuré pour détecter le niveau d'un fluide dans le réservoir en utilisant la carte de circuit imprimé (9) comprenant des commutateurs (11) qui sont des commutateurs Reed.
